# EUROPEAN PATENT SPECIFICATION

(11) **EP 3 944 317 B1**
(45) Date of publication and mention of the grant of the patent: **02.09.2026**
(21) Application number: 20187055.7
(22) Date of filing: 21.07.2020
(51) Int. Cl.: H10D 89/60, H02H 9/04

(54) **AN ELECTROSTATIC DISCHARGE PROTECTION SEMICONDUCTOR STRUCTURE AND A METHOD OF MANUFACTURE**
HALBLEITERSTRUKTUR MIT SCHUTZ VOR ELEKTROSTATISCHER ENTLADUNG UND VERFAHREN ZUR HERSTELLUNG
STRUCTURE SEMICONDUCTRICE DE PROTECTION CONTRE LES DÉCHARGES ÉLECTROSTATIQUES ET PROCÉDÉ DE FABRICATION

(43) Date of publication of application: 26.01.2022
(73) Proprietor: Nexperia B.V., 6534 AB Nijmegen (NL)
(72) Inventor: Ritter, Hans-Martin, 6534 AB Nijmegen (NL); Zimmerman, Andreas, 6534 AB Nijmegen (NL)
(74) Representative: Pjanovic, Ilija

(56) References cited:
- US-A1- 2004 190 209
- US-A1- 2008 218 920
- US-B1- 6 724 592
- US-B1- 7 978 450

## Description

### FIELD

The present invention relates to an electrostatic discharge protection semiconductor structure. The invention also relates to an integrated circuit comprising an electrostatic discharge protection semiconductor structure.

### BACKGROUND

A known monolithically integrated electrostatic discharge (ESD) protection device is described in patent US7227730.

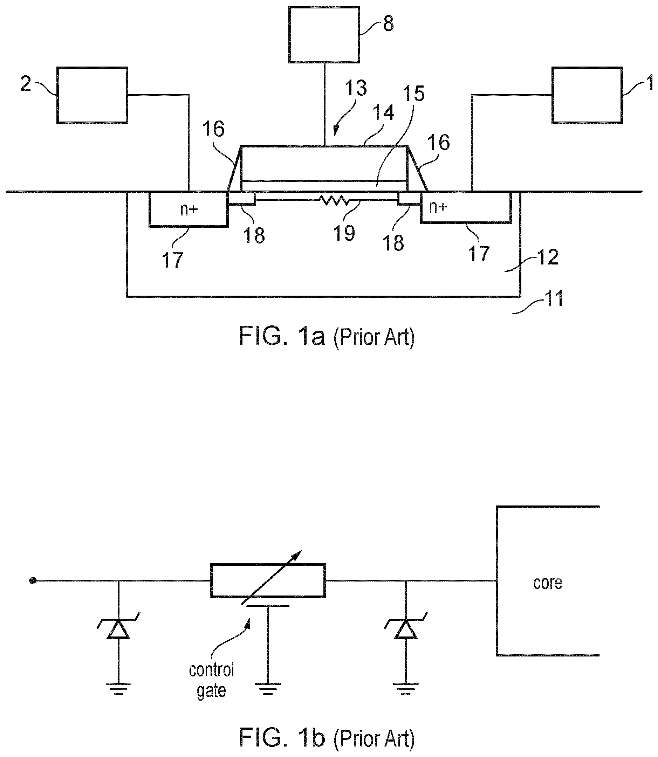

Such a monolithically integrated ESD protection device is schematically shown in Figure 1a. The monolithically integrated ESD protection device comprises a lateral field effect transistor structure, for example with a MOS gate structure. The device further comprises a high impedance biasing circuit 8. The device operates as a varistor for current limitation purposes.

The monolithically integrated ESD protection device is interconnected between input/output terminal of a high frequency or radio frequency MOS circuit 1 one side, and input/output bonding pad 2 from other side.

The lateral MOS transistor based varistor structure is formed in a p-type doped substrate 11. The lateral MOS transistor based varistor structure comprises an n-type doped well region 12, a gate region 13 including a silicon gate layer region 14 and a gate oxide layer region 15 arranged on top of the n-type doped well region 12. An electrically insulating sidewall spacer 16 is formed on each side of the gate region 13 to avoid short-circuiting of the structure. Heavily n+-type doped source and drain regions 17 are formed in the n-type doped well region 12 at a respective side of the gate region 13. One of the drain and source regions 17 is connected to the input/output bonding pad 2, and the other one of the drain and source regions 17 is connected to the input/output terminal of the MOS circuit 1.

The MOS transistor structure may include one or two lightly doped drain and/or pocket regions 18 as are commonly formed for MOS transistors. The resistance path between the drain and source regions 17 is schematically indicated by reference numeral 19.

The high impedance biasing circuit 8 is connected to the silicon gate layer region 14 and should have an impedance at the operating frequency, which is higher or much higher than the impedance of the capacitance associated with the gate oxide layer region 15, thus reducing the parasitic load on the input/output of the MOS circuit 1.

In this way the varistor shown in Figure 1 is arranged to increase the resistance between the drain and source regions 17 at high voltages, e.g. at a voltage higher than normal operating voltages of the semiconductor device, to thereby limit a potentially damaging current from the input/output bonding pad 2 to the input/output of the circuit 1, or a similar current in an opposite direction.

It shall be noted that the ESD protection is mainly intended to be present during handling of the semiconductor device, i.e. when it is not connected to electrical power. Nevertheless, a current limitation operation is also present when the gate layer region 14 is biased.

At normal operating voltages of the semiconductor device, an accumulation region is created below the gate region by means of the biasing of the gate layer region 14 of the field effect transistor structure, thus decreasing actively the varistor series resistance.

The disadvantage of the monolithically integrated ESD protection device as described above is that the voltage drop across the varistor is due to the non-linear resistance of a low doped region. Such a device does not show the saturation effect of an inversion layer. Such a low doped resistor will show an avalanche breakdown for high voltages too. This is a so-called 'second breakdown' because it happens in a n+/n-/n+ structure. There is a strong risk that the device gets damaged when said 'second breakdown' occurs.

Another known embodiment for the ESD protection is presented in Figure 1b. In this case the voltage-controlled non-linear resistors (varistors) are used as a serial impedance. The result is a low serial impedance for normal working conditions, thus, not hampering data transfer through the line, and a high impedance for over-voltage conditions. Such solutions are either not robust or add capacitive load to the data line via the control gate used for switching from low to high impedance. Therefore, their use is limited to low-data-rate signal lines where the restrictions concerning the allowable parasitic load for the signal line are relaxed.

### SUMMARY

Various example embodiments are directed to the disadvantage as described above and/or others which may become apparent from the following disclosure.

The invention concerns an electrostatic discharge protection semiconductor structure as defined in claim 1. Preferred embodiments are defined in the dependent claims.

According to an embodiment of this invention an electrostatic discharge protection semiconductor structure comprises:
- a first protection stage,
- a second protection stage, and
- an inversion layer resistor arranged between the first protection stage and the second protection stage.

Such an electrostatic discharge protection semiconductor structure can be arranged in an integrated circuit for providing an advantageous electrostatic discharge protection. It secures that integrated circuit cannot be damaged when a 'second breakdown' occurs.

According to an embodiment of this invention the inversion layer resistor comprises:
- a p-doped substrate, and
- a first n+-diffusion and a second n+-diffusion in the p-doped substrate.

The inversion layer resistor further comprises an inversion layer that is connecting the first n+-diffusion and the second n+-diffusion. The inversion layer comprises an oxide layer that covers the area between the first n+-diffusion and the second n+-diffusion. The terminals of the inversion layer are positioned at the first n+-diffusion and the second n+-diffusion and these terminals are connected to the first protection stage ad the second protection stage.

According to the claimed invention, the inversion layer is created by the oxide charges of the oxide layer.

In an embodiment of the invention an electrostatic discharge protection semiconductor structure comprises an inversion layer resistor, wherein the inversion layer resistor comprises:
- a p-doped substrate,
- a first n+-diffusion and a second n+-diffusion in the p-doped substrate, and
- a depletion mode MOS transistor arranged between the first n+-diffusion and the second n+-diffusion.

The depletion mode MOS transistor can comprise a gate and a back-gate, wherein the gate and the back-gate are connected to each other.

In an embodiment of the invention an integrated circuit comprises an electrostatic discharge protection semiconductor structure as specified in the previous embodiments.

It is also described a method of creating an electrostatic discharge protection semiconductor structure as specified in the previous embodiments and a method of creating an integrated circuit comprising an electrostatic discharge protection semiconductor structure as described in the previous embodiments.

### DESCRIPTION OF THE DRAWINGS

So that the manner in which the features of the present disclosure can be understood in detail, a more particular description is made with reference to embodiments, some of which are illustrated in the appended figures. It is to be noted, however, that the appended figures illustrate only typical embodiments and are therefore not to be considered limiting of its scope. The figures are for facilitating an understanding of the disclosure and thus are not necessarily drawn to scale. Advantages of the subject matter claimed will become apparent to those skilled in the art upon reading this description in conjunction with the accompanying figures, in which like reference numerals have been used to designate like elements, and in which:
Figures 1a and 1b show a known monolithically integrated ESD protection device and a known embodiment for the ESD protection respectively;
Figure 2 illustrates a semiconductor device according to an embodiment of the invention;
Figure 3 illustrates a semiconductor device according to an embodiment of the invention;
Figure 4 illustrates a voltage-current dependency for a semiconductor device according to an embodiment of the invention;
Figure 5 illustrates a semiconductor device according to an embodiment of the invention;
Figure 6 illustrates a semiconductor device according to an embodiment of the invention;
Figure 7 illustrates a semiconductor device according to an embodiment of the invention.

### DETAILED DESCRIPTION

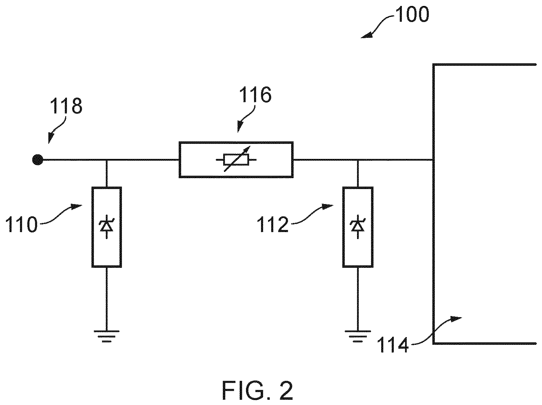

Figure 2 illustrates an embodiment of the present invention with a two stage ESD protections structures. Such two stage ESD protection structures can be either built fully on-chip or consisting of an off-chip protection device in combination with the on-chip protection structure. The two structures provide low ohmic current paths to supply lines in combination with an impedance 116 that forms part of the data line.

A two stage ESD protections structure device comprises the first stage protection device 110 and the in-line impedance 116. The second stage 112 can be an input ESD protection structure of the integrated circuit to be protected wherein reference 114 is used to show a core of such an integrated circuit.

In this embodiment the stress current is divided between the first stage 110 and the second stage 112 following Kirchhoff's rules, which rules are known to a skilled person.

This embodiment secures that the clamping voltage of the second stage 112 is reduced. This clamping voltage is limited by the allowed voltage of the core of the integrated circuit 112 to be protected. The clamping voltage at the second stage 112 depends on the current through the second stage 112. Therefore, it is important to minimize the current through the second stage 112. This can be achieved by increasing the serial impedance 116. From other side the data transfer restrictions limit the allowed value of the serial impedance 116.

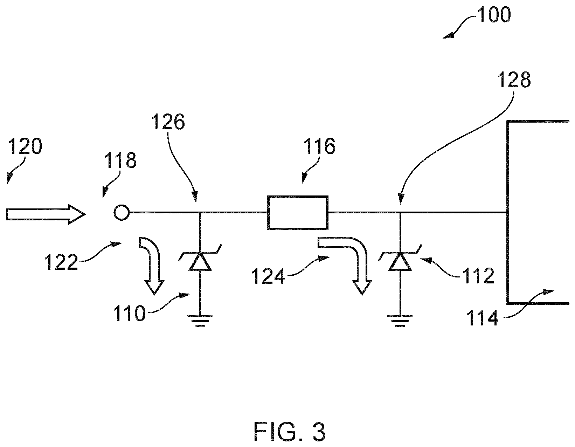

Figure 3 illustrates an embodiment of the present invention with a two stage ESD protections structures wherein the current distribution is shown. The stress current 120 is divided between the current through the first stage 122 and the current through the second stage 124. The current through the first stage 122 and the first stage 110 define the first clamping voltage V1. The current through the second stage 124 and the second stage 112 define the second clamping voltage V2. As said previously the second clamping voltage V2 is low so that the integrated circuit is ESD protected.

According to an embodiment of the invention a robust current limiting device is provided, wherein such a device can be placed into the signal line and it does not add to the capacitive load of the line.

According to the embodiment of the invention an inversion layer resistor is used. In this case, due to the pinch-off effect of the inversion layer, that gives rise to current saturation, increasing the voltage drop along the layer does not increase the current.

Under normal conditions, e.g. during the data transfer mode, the inversion layer resistor, when designed with a sufficient width-length ratio, it shows ohmic behaviour. The resistance can be designed to be small enough, e.g. less than 1 Ohm, and it will therefore not hamper data transfer.

Under stress conditions the inversion layer resistor will show current saturation, thus limiting the current that reaches the second stage protection shunt. If the clamping voltage V1 126 at the first stage 110 exceeds the breakdown voltage of the transistor that form the contacts for the inversion layer resistor, more current may flow to the second stage 112. But the current through the second stage 124 will still be reduced, because the breakdown voltage of the transistor adds to the total voltage drop of the second current path 124. This reduction will be improved if the breakdown voltage of the transistor is chosen high enough.

No control gates or trigger circuits are necessary for such an inversion layer resistor. Therefore, the capacitive load of the signal line is not influenced, and the signal transfer is not hampered.

The combination of current-limiting capability and capacitive-neutral insertion makes the device useful for the ESD and/or surge protection of high-rate data inputs/outputs of modern integrated circuits.

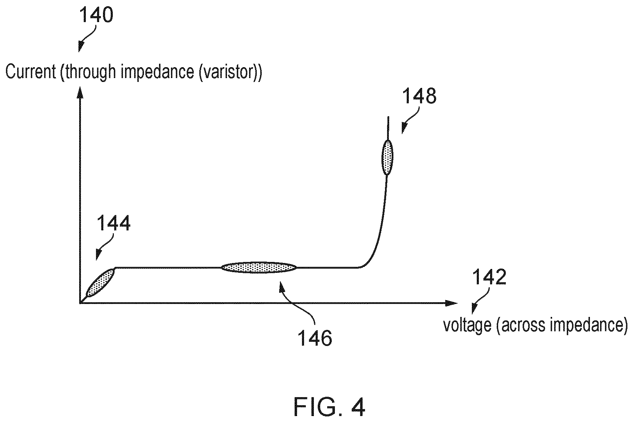

The dependence of the current through impendence 140, i.e. varistor, on the voltage across impendence 142 is shown in Figure 4. For the lower voltages 144 the curve represents an ohmic behaviour. After that there is the current limitation by saturation 146. The last part represents the clamping voltage of an open base transistor in a breakdown 148.

An inversion according to the claimed invention is produced by combining fixed oxide charges with low p-doping level.

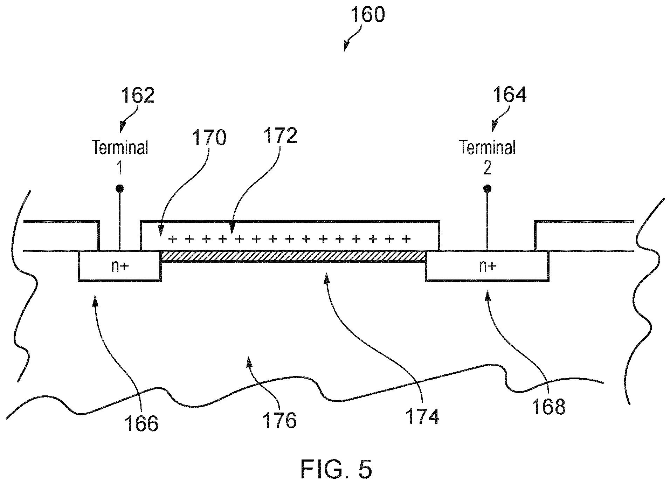

An embodiment of the invention is shown in Figure 5. A device 160 comprises two terminals, a first terminal 162 and a second terminal 164. The first terminal and the second terminal are connected to a first n+ diffusion 166 and to a second n+ diffusion 168 respectively, which the first n+ diffusion 166 and the second n+ diffusion 168 are provided in a lowly p-doped substrate 176.

The first n+ diffusion 166 and the second n+ diffusion 168 are connected by an inversion layer 174, created by oxide charges 172 in the oxide layer 170 that covers the area between the first n+ diffusion 166 and the second n+ diffusion 168.

The above described device with its two terminals 162 and 164 is placed into the signal line between two protection devices 110 and 112, as shown in Figure 2, and it is placed where the 'impedance' 116 is shown in Figure 1.

The two contact diffusions, the first n+ diffusion 166 and the second n+ diffusion 168, form an open-base transistor together with the p-doped substrate 176. As described above, this transistor might be driven into breakdown mode if the clamping voltage at the first protection stage 110 surpasses the trigger voltage. This parallel current path, parallel to the current limited inversion layer resistor, that has no obvious current limitation is advantageous for the protection of the second stage 112 protection device. The breakdown voltage of this transistor, which is normally above 20 Volt, adds to the total voltage of the second path, still reducing drastically the current 124 through the second stage 112. Further, this parallel current path protects the inversion layer resistor from being damaged by a too high voltage drop across the inversion layer resistor. This improves the robustness of the device in case of overvoltage/overcurrent stress pulses.

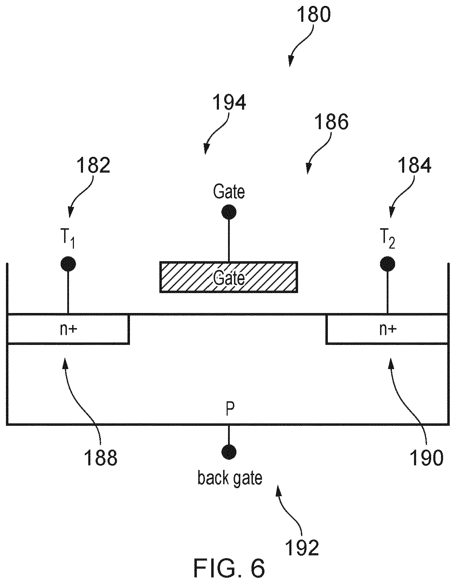

An embodiment of the invention is shown in Figure 6. A device 180 comprises a depletion mode MOS transistor 194. The depletion mode MOS transistor has an inversion layer below the gate even at zero voltage difference between the gate 186 and the back-gate 192.

In general, a MOS transistor is basically a four-terminal device, it comprises two input/output terminals, a first terminal 182 and a second terminal 184. The MOS transistor further comprises a gate terminal 186 and a back-gate terminal 192. If the voltage between the gate terminal 186 and the back-gate terminal 192 is larger than the threshold voltage of the specific transistor an inversion layer below the gate terminal 186 will connect the first terminal 182 and the second terminal 184.

In an embodiment of the invention the depletion mode MOS transistor 194 is placed into the signal line, the first terminal 182 and the second terminal 184 are connected to either side of the signal line.

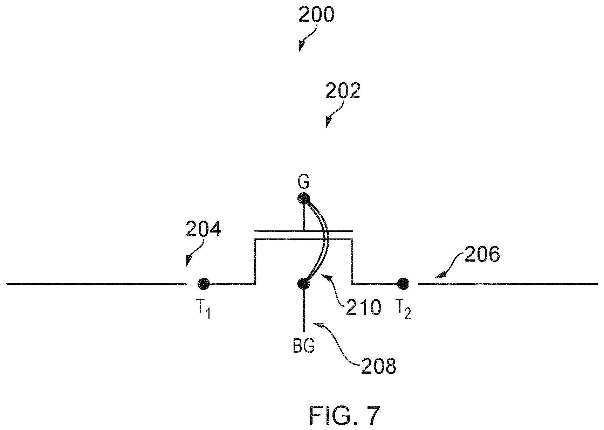

As shown in an embodiment of the invention in Figure 7, for the depletion mode MOS transistor 200, this means that the inversion layer will connect the first terminal 204 and the second terminal 206 even if the voltage difference between the gate terminal 202 and the back-gate terminal 208 is zero.

When the gate terminal 202 and the back-gate terminal 208 are shorted 210 together, the depletion mode MOS transistor is in the conduction mode.

Term "comprising" does not exclude other elements or steps, the term "a" or "an" does not exclude a plurality. Reference signs in the claims shall not be construed as limiting the scope of the claims.

## Claims

1. An electrostatic discharge protection semiconductor structure comprising an inversion layer resistor (116) arranged to secure the electrostatic discharge protection,
- wherein the electrostatic discharge protection semiconductor structure comprises:
- a first protection stage (110),
- a second protection stage (112),
- wherein the inversion layer resistor is arranged between the first protection stage and the second protection stage,
- **characterized in that** the inversion layer is created by the oxide charges (172) in an oxide layer (170) on top of the resistive layer.

2. An electrostatic discharge protection semiconductor structure as claimed in claim 1, wherein the inversion layer resistor comprises:
- a p-doped substrate,
- a first n+-diffusion and a second n+-diffusion in the p-doped substrate, and
- an inversion layer that is connecting the first n+-diffusion and the second n+-diffusion.

3. An electrostatic discharge protection semiconductor structure as claimed in claim 2, wherein an oxide layer that covers the area between the first n+-diffusion and the second n+-diffusion.

4. An electrostatic discharge protection semiconductor structure as claimed in claim 2, wherein the inversion layer resistor comprises:
- a p-doped substrate,
- a first n+-diffusion and a second n+-diffusion in the p-doped substrate, and
- a depletion mode MOS transistor arranged between the first n+-diffusion and the second n+-diffusion.

5. An electrostatic discharge protection semiconductor structure as claimed in claim 4, wherein the depletion mode MOS transistor comprises a gate and a back-gate, wherein the gate and the back-gate are connected to each other.

6. An integrated circuit comprising an electrostatic discharge protection semiconductor structure as claimed in any of the previous claims.

## Patentansprüche

1. Halbleiterstruktur zum Schutz vor elektrostatischer Entladung, die einen Inversionsschichtwiderstand (116) umfasst, der dazu angeordnet ist, den Schutz vor elektrostatischer Entladung zu sichern,
- wobei die Halbleiterstruktur zum Schutz vor elektrostatischer Entladung Folgendes umfasst:
- eine erste Schutzstufe (110),
- eine zweite Schutzstufe (112),
- wobei der Inversionsschichtwiderstand zwischen der ersten Schutzstufe und der zweiten Schutzstufe angeordnet ist,
- **dadurch gekennzeichnet, dass** die Inversionsschicht durch die Oxidladungen (172) in einer Oxidschicht (170) auf der Widerstandsschicht hergestellt wird.

2. Halbleiterstruktur zum Schutz vor elektrostatischer Entladung nach Anspruch 1, wobei der Inversionsschichtwiderstand Folgendes umfasst:
- ein p-dotiertes Substrat,
- eine erste n+-Diffusion und eine zweite n+-Diffusion in dem p-dotierten Substrat und
- eine Inversionsschicht, die die erste n+-Diffusion und die zweite n+-Diffusion verbindet.

3. Halbleiterstruktur zum Schutz vor elektrostatischer Entladung nach Anspruch 2, wobei eine Oxidschicht, die den Bereich zwischen der ersten n+-Diffusion und der zweiten n+-Diffusion bedeckt.

4. Halbleiterstruktur zum Schutz vor elektrostatischer Entladung nach Anspruch 2, wobei der Inversionsschichtwiderstand Folgendes umfasst:
- ein p-dotiertes Substrat,
- eine erste n+-Diffusion und eine zweite n+-Diffusion in dem p-dotierten Substrat und
- einen zwischen der ersten n+-Diffusion und der zweiten n+-Diffusion angeordneten Verarmungs-MOS-Transistor.

5. Halbleiterstruktur zum Schutz vor elektrostatischer Entladung nach Anspruch 4, wobei der Verarmungs-MOS-Transistor ein Gate und ein Rückseitengate umfasst, wobei das Gate und das Rückseitengate miteinander verbunden sind.

6. Integrierte Schaltung, die eine Halbleiterstruktur zum Schutz vor elektrostatischer Entladung nach einem der vorhergehenden Ansprüche umfasst.

## Revendications

1. Structure semiconductrice de protection contre les décharges électrostatiques comprenant une résistance de couche d'inversion (116) agencée pour sécuriser la protection contre les décharges électrostatiques,
- dans laquelle la structure semiconductrice de protection contre les décharges électrostatiques comprend :
- un premier étage de protection (110),
- un second étage de protection (112),
- dans laquelle la résistance de couche d'inversion est agencée entre le premier étage de protection et le second étage de protection,
- **caractérisée en ce que** la couche d'inversion est créée par les charges d'oxyde (172) dans une couche d'oxyde (170) au sommet de la couche résistive.

2. Structure semiconductrice de protection contre les décharges électrostatiques selon la revendication 1, dans laquelle la résistance de couche d'inversion comprend :
- un substrat dopé p,
- une première diffusion n+ et une seconde diffusion n+ dans le substrat dopé p, et
- une couche d'inversion qui connecte la première diffusion n+ et la seconde diffusion n+.

3. Structure semiconductrice de protection contre les décharges électrostatiques selon la revendication 2, dans laquelle une couche d'oxyde qui couvre la zone entre la première diffusion n+ et la seconde diffusion n+.

4. Structure semiconductrice de protection contre les décharges électrostatiques selon la revendication 2, dans laquelle la résistance de couche d'inversion comprend :
- un substrat dopé p,
- une première diffusion n+ et une seconde diffusion n+ dans le substrat dopé p, et
- un transistor MOS à mode de déplétion agencé entre la première diffusion n+ et la seconde diffusion n+.

5. Structure semiconductrice de protection contre les décharges électrostatiques selon la revendication 4, dans laquelle le transistor MOS à mode de déplétion comprend une grille et une grille arrière, dans laquelle la grille et la grille arrière sont connectées l'une à l'autre.

6. Circuit intégré comprenant une structure semiconductrice de protection contre les décharges électrostatiques selon l'une quelconque des revendications précédentes.
